# EUROPÄISCHE PATENTANMELDUNG

(11) **EP 0 584 443 A1**
(43) Veröffentlichungstag der Anmeldung: **02.03.1994**
(21) Anmeldenummer: 93102583.7
(22) Anmeldetag: 19.02.1993
(51) Int. Cl.: C23C 14/56, C23C 14/02, C23C 14/20

(54) **Verfahren und Vorrichtung zum kontinuierlichen Beschichten von nichtleitenden Folien im Vakuum**

(30) Priorität: 22.08.1992 DE 4227873
(71) Anmelder: LEYBOLD AKTIENGESELLSCHAFT, D-63450 Hanau (DE)
(72) Erfinder: Bauer, Volker, W-6451 Neuberg (DE); Löbig, Gerard, Dipl.-Ing., W-6000 Frankfurt/Main 90 (DE); Krug, Thomas, Dr.-Phys., W-6458 Rodenbach (DE); Feuerstein, Albert, Dr. Phys., W-6454 Bruchköbel (DE); Hoffmann, Gerd, Dipl.-Ing., W-6454 Bruchköbel 4 (DE)

(57) **Zusammenfassung**

Bei einem Verfahren und in einer Vorrichtung zum kontinuierlichen Beschichten von nichtleitenden Folien wird mittels einer Hochleistungs-Beschichtungsquelle im Vakuum das Beschichtungsmaterial auf einem auf einer rotierenden Kühlwalze aufliegenden Abschnitt der Folie niedergeschlagen. Vor dem Beschichten wird die Folie mit Ladungsträgern beschossen, um den Ladungszustand der Folie zu verändern. Um einerseits die Folie an die Kühlwalze anzupressen, andererseits aber die thermische Belastung der Folie durch Beschuß mit Ladungsträgern zu begrenzen, wird die Folie während ihrer Auflage auf der Kühlwalze vor dem Beschichten einem Elektronenbeschuß durch einen thermischen Emitter mit einer Spannung zwischen 3 und 10 kV, vorzugsweise zwischen 4 und 8 kV, ausgesetzt.

## Beschreibung

Die Erfindung betrifft ein Verfahren zum kontinuierlichen Beschichten von nichtleitenden Folien mittels einer Hochleistungs-Beschichtungsquelle im Vakuum unter Kondensation des Beschichtungsmaterials auf einem auf einer rotierenden Kühlwalze oberhalb der Hochleistungs-Beschichtungsquelle aufliegenden Abschnitt der Folie und unter Beaufschlagung der Folie vor dem Beschichten mit Ladungsträgern, um den Ladungszustand der Folie zu verändern.

Durch die DE-OS 22 33 258 und die DE-OS 23 11 217 ist es bekannt, eine laufende Kunststoff-Folie auf einer Kühlwalze durch Vakuumbedampfen zu metallisieren und den bereits metallisierten Teil der Folie über eine unter Spannung stehende Kontaktwalze zu führen, um die Folie zur Verbesserung des Wärmeübergangs elektrostatisch an die Kühlwalze anzupressen. Diese Maßnahme läßt sich jedoch nur bei einer elektrisch leitenden Beschichtung der Folie anwenden. Außerdem wird die Anpreßwirkung bei Verwendung eines Elektronenstrahlverdampfers wieder vermindert, weil die auf dem leitfähigen Belag auftreffenden Elektronen den Einfluß der Kontaktwalze zumindest teilweise wieder zunichte machen.

Durch die US-PS 4 393 091 ist es bekannt, eine Kunststoff-Folie vor dem Beschichten mit einem Metall durch Elektronenbeschuß mit einer Beschleunigungsspannung zwischen 20 und 60 kV in ein Elektret umzuwandeln, um gleichfalls eine elektrostatische Anpressung der Folie an die Kühlwalze herbeizuführen. Da hierdurch die Wickeleigenschaften der Folie im Sinne einer Faltenbildung negativ beeinflußt werden, muß die Folie nach dem Beschichten, aber vor dem Aufwickeln einer Glimmbehandlung ausgesetzt werden. Der Beschuß der Folie mit derart hochbeschleunigten Elektronen führt in Verbindung mit der thermischen Belastung durch die Verdampferquelle und nicht zuletzt durch die erneute Aufheizung durch die Glimmentladung zu einer hohen thermischen Belastung der Folie, so daß der Prozeß regelungstechnisch schwer beherrschbar ist. Auch die zusätzlich noch angegebenen Beschichtungsverfahren durch Katodenzerstäubung, Ionenimplantation etc. ändern nichts an der hohen thermischen Belastung der Folie, zumal der Beschuß mit den hochenergetischen Elektronen nicht in einem Bereich der Folie erfolgt, die auf der Kühlwalze aufliegt.

Durch die US-PS 4 581 245 ist es bekannt, magnetische Schichten mittels eines seitlich zur Achse der Kühlwalze versetzten Verdampfers unter einem spitzen Winkel auf die laufende Folie aufzudampfen. In Laufrichtung der Folie sind dem Verdampfer für die Magnetwerkstoffe eine gitterförmige Elektrode für einen Ionenbeschuß der bereits aufgedampften Schicht und ein weiterer Verdampfer für ein Gleitmittel nachgeschaltet. Der Ionenbeschuß dient unter gleichzeitiger Zufuhr von Sauerstoff zu einer Oxidation der Magnetwerkstoffe. Die gitterförmige Elektrode hat keinerlei Einfluß auf die Anpressung der Folie an die Kühlwalze während der Bedampfung mit dem Magnetwerkstoff.

Durch die US-PS 4 495 242 ist ein ähnliches Verfahren bekannt, bei dem die Folie vor dem Aufdampfen des Magnetwerkstoffs mittels eines Elektronenstrahlverdampfers frei ausgespannt zwischen einer ganzen Reihe von Elektrodenpaaren hindurchgeführt wird, die zur Herbeiführung einer Glimmentladung dienen. Die Glimmentladung findet unter Zufuhr von Argon bei Spannungen im Bereich zwischen 0,4 und 5 kV statt, wodurch die Folienoberfläche gereinigt und ihre Haftfähigkeit gegenüber der nachfolgend aufgebrachten Magnetschicht verbessert wird. Da die glimmbehandelte Folie nachfolgend wieder über auf Erdpotential liegende Umlenkrollen geführt wird, hat die Glimmbehandlung keinerlei Einfluß auf die Anpressung der Folie an die Kühlwalze.

Durch die DE-OS 36 41 718 ist es schließlich bekannt, eine noch unbeschichtete Kunststoff-Folie mittels einer Glimmentladung zu reinigen und zu entgasen und eine elektrostatische Aufladung der bereits beschichteten Folie durch eine Plasmabehandlung zu verringern. Diese Maßnahme hat den Zweck, die durch Streu-Elektronen verursachte elektrostatische Ansaugung der Folie an die Kühlwalze abzubauen, um eine Faltenbildung auf der Aufwickelrolle zu vermeiden. Einen Schutz gegen Überhitzung der Folie kann eine solche Maßnahme wegen der verspäteten Einwirkung des Plasmas nicht gewährleisten. Auch bei dem hierdurch bekannten Verfahren haben die thermischen Einflüsse der Glimmentladung, der Beschichtungsquelle und der nachträglichen Plasmabehandlung eine additive Wirkung.

Im übrigen ergibt sich aus dem Stande der Technik, daß sich die Einwirkungen elektrostatischer Aufladungen der Folie vor und nach der Beschichtung diametral entgegenstehen. Einerseits wird eine elektrostatische Aufladung der Folie zur Verbesserung des Wärmeübergangs zwischen Folie und Kühlwalze erwünscht, andererseits führt nun ausgerechnet diese an sich positive Wirkung zu erheblichen Störungen beim Aufwickeln durch Faltenbildung.

Der Erfindung liegt daher die Aufgabe zugrunde, ein Verfahren der eingangs beschriebenen Gattung anzugeben, das sowohl bei leitenden als auch bei nicht-leitenden Schichten zur elektrostatischen Anpressung der Folie an die Kühlwalze führt, ohne aber andererseits die Folie mit einer solchen Oberflächenaufladung zu belasten, daß dies zur Faltenbildung beim Aufwickeln führen könnte.

Die Lösung der gestellten Aufgabe erfolgt bei dem eingangs beschriebenen Verfahren erfindungsgemäß dadurch, daß die Folie während ihrer Auflage auf der Kühlwalze vor dem Beschichten einem Elektronenbeschuß durch einen thermischen Emitter mit einer Spannung zwischen 3 und 10 kV, vorzugsweise zwischen 4 und 8 kV, ausgesetzt wird.

Durch eine einzige Maßnahme mit Wahl einer Spannung innerhalb des angegebenen Spannungsbereichs ist es mithin möglich, der Folie eine ausreichende elektrostatische Anziehungskraft an die Kühlwalze zu verleihen, andererseits aber das Abziehen der Folie von der Kühlwalze nicht zu erschweren und schließlich ein faltenfreies Aufwickeln ohne eine Vielzahl von Umlenkwalzen zu ermöglichen.

Unter dem Ausdruck "Hochleistungs-Beschichtungsquellen" werden solche Beschichtungsquellen verstanden, die im Stande sind, pro Längeneinheit der Kühlwalze eine große Materialmenge pro Zeiteinheit freizusetzen. Hierfür besonders geeignet sind Elektronenstrahlverdampfer, Magnetron-Zerstäubungskatoden und thermisch beheizte ungekühlte Verdampferschiffchen. Den vorstehend beschriebenen Beschichtungsquellen ist es gemeinsam, daß sie zur Freisetzung einer ausreichenden Menge von Beschichtungsmaterial pro Längeneinheit der Kühlwalze mit hohen Temperaturen arbeiten müssen.

Beim Einsatz sogenannter Elektronenstrahlverdampfer kommt noch folgender Effekt hinzu: Beim kontinuierlichen Betrieb eines Elektronenstrahlverdampfers werden von der Oberfläche des vom Elektronenstrahl beaufschlagten Verdampfungsgutes kontinuierlich Sekundärelektronen freigesetzt, die die Folie aufladen und dadurch die Anpresskraft der Folie an die Kühlwalze verbessern. Wird nun der Elektronenstrahl für kurze Zeit abgeschaltet, was üblicherweise durch eine automatische Regelung beim Auftreten von Spannungsüberschlägen bzw. Lichtbögen geschieht, so gerät die elektrostatische Anpressung durch die Sekundärelektronen kurzzeitig in Fortfall, während die Wärmestrahlung durch die Oberfläche des Verdampfungsgutes jedoch zunächst unverändert fortbesteht. Dies führt zu einem sofortigen Durchbrennen der Folie und zu einer Unterbrechung des Beschichtungsprozesses, der ohne Fluten der Vakuumkammer, Beseitigung des Störungszustandes und erneutes Evakuieren der Vakuumkammer nicht weitergeführt werden kann. Erhebliche Stillstandszeiten der Anlage sind die Folge, wobei von der Überlegung auszugehen ist, daß Spannungsüberschläge und Lichtbögen durch das sogenannte "Ausgasen" der Folie begünstigt werden.

Es ist dabei besonders vorteilhaft, wenn die Folie aus einer Wickelkammer mit einem Druck zwischen 10⁻² und 10⁻³ mbar abgezogen, durch eine Zwischenkammer mit einem Druck zwischen 10⁻³ und 10⁻⁴ mbar hindurch in eine Beschichtungskammer mit einem Druck zwischen 10⁻⁴ und 10⁻⁵ mbar geführt, beschichtet und mit umgekehrten Druckverhältnissen wieder in die Wickelkammer zurückgeführt wird, wobei der Elektronenbeschuß in der Zwischenkammer durchgeführt wird.

Durch diese Trennung der einzelnen Verfahrensabschnitte beeinflussen sich die Verfahrensbedingungen nicht gegenseitig.

Die Erfindung betrifft auch eine Vorrichtung zur Durchführung eines derartigen Verfahrens mit einer Hauptvakuumkammer, die durch Trennwände in mindestens zwei unabhängig voneinander evakuierbare Teilkammern unterteilt ist, die eine Wickelkammer und eine Beschichtungskammer bilden, mit einer drehbaren Kühlwalze, die in Fenstern der Trennwände angeordnet ist, wobei die Fensterkanten gegenüber der Kühlwalze und der Folie Spaltblenden bilden.

Eine solche Vorrichtung ist zur Lösung der gleichen Aufgabe erfindungsgemäß dadurch gekennzeichnet, daß außerhalb der Beschichtungskammer ein thermischer Elektronen-Emitter angeordnet ist, durch den Elektronen in Richtung auf die Kühltrommel beschleunigbar sind.

Eine wiederum vorteilhafte Ausgestaltung einer derartigen Vorrichtung ist gemäß der weiteren Erfindung dadurch gekennzeichnet, daß der Elektronen-Emitter ein parallel zur Achse der Kühlwalze verlaufender, auf Emissionstemperatur aufheizbarer Glühdraht ist, der von einer Hohlanode umgeben ist, die in Richtung auf die Kühlwalze einen Schlitz für den Austritt der Elektronen aufweist, im übrigen aber geschlossen ist.

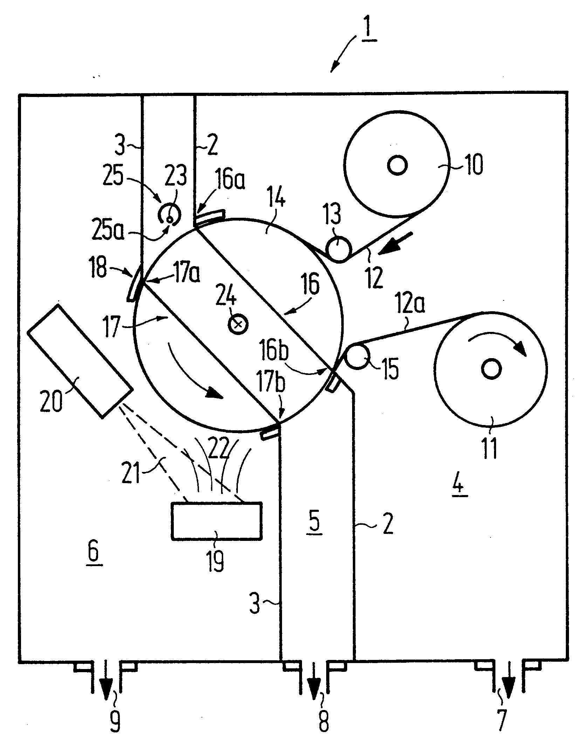

Ein Ausführungsbeispiel des Erfindungsgegenstandes wird nachfolgend anhand der einzigen Figur erläutert, die einen Vertikalschnitt durch eine Vorrichtung mit einem Elektronenstrahlverdampfer zeigt.

In der Figur ist eine Hauptvakuumkammer 1 dargestellt, die durch zwei Trennwände 2 und 3 in drei unabhängig voneinander evakuierbare Teilkammern 4, 5 und 6 unterteilt ist. Jede dieser Teilkammern ist über jeweils einen Saugstutzen 7, 8 oder 9 an einen nicht dargestellten Vakuum-Pumpsatz angeschlossen.

Die Teilkammer 4 ist die sogenannte Wickelkammer; in ihr befinden sich die Abwickelrolle 10, die auch als Vorratsrolle bezeichnet wird, und die Aufwickelrolle 11. Von der Abwickelrolle 10 wird die Folie 12 zur Vergrößerung des Umschlingungswinkels über eine Umlenkwalze 13 auf die eigentliche Kühlwalze 14 geführt. Nach einem Umschlingungswinkel, der nahezu 300 Grad beträgt, wird die nunmehr beschichtete Folie 12a über eine weitere Umlenkwalze 15 abgezogen und auf der Aufwickelrolle 11 aufgewickelt. Die einzelnen Rollen bzw. Walzen werden dabei zum Zwecke der Einhaltung einer vorgegebenen Zugspannung in engen Grenzen geregelt angetrieben.

Die Kühlwalze 14 durchsetzt in der dargestellten Weise die beiden Trennwände 2 und 3, die an der Stelle der Kühlwalze 14 mit entsprechenden Fenstern 16 und 17 versehen sind, deren Fensterkanten 16a und 16b bzw. 17a und 17b gegenüber der Kuhlwalze 14 und der auf ihr aufliegenden Folie 12 bzw. 12a Spaltblenden bilden. Zur Verbesserung der Abdichtung besitzen die Fensterkanten sogenannte Spaltbleche 18, von denen nur eines bezeichnet ist. Die Krümmung dieser Spaltbleche ist derjenigen der äußeren Zylinderfläche der Kühlwalze 14 geometrisch ähnlich.

Unter der tiefsten Mantellinie der Kühlwalze 14 befindet sich ein langgestreckter, rechteckiger und ungekühlter Verdampfertiegel 19 aus einem keramischen Werkstoff, in dem sich das hier nicht näher bezeichnete Verdampfungsmaterial befindet. Die Länge des Verdampfertiegels 19 (senkrecht zur Zeichenebene gesehen) entspricht dabei der axialen Länge der Kühlwalze 14. Der Verdampfertiegel 19 wird mittels einer Elektronenstrahlkanone 20 beheizt, die einen Elektronenstrahl 21 mit einer Strahlspannung von 20 kV erzeugt. Der Elektronenstrahl wird in an sich bekannter Weise nach einem gespeicherten Ablenkmuster periodisch über die gesamte Oberfläche des Verdampfungsgutes geführt, so daß im Ergebnis ein kontinuierlicher Dampfstrom 22 von dem Verdampfertiegel 19 aufsteigt und auf der Folie 12 kondensiert.

Im oberen Bereich der als Zwischenkammer dienenden Teilkammer 5 befindet sich ein thermischer Elektronen-Emitter 23, der aus einem linear ausgespannten Draht besteht, dessen beide Enden an eine hier nicht gezeigte Spannungsquelle gelegt sind. Der Elektronen-Emitter 23 befindet sich auf einem Spannungspegel von 6 kV negativ und sendet in Richtung auf die Kühltrommel 14 einen diffusen Elektronenschleier aus, der durch die Potentialdifferenz zwischen Emitter und Kühltrommel beschleunigt wird. Die Kühltrommel liegt üblicherweise auf Massepotential.

Der Elektronen-Emitter 23 verläuft parallel zur Achse 24 der Kühlwalze 14 und ist von einer Hohlanode 25 umgeben, die als hohler Teilzylinder ausgebildet ist und in der Länge der Länge des Elektronen-Emitters entspricht. Die Hohlanode 25 besitzt in Richtung auf die Kühlwalze einen Schlitz 25a, durch die die Elektronen gerichtet austreten.

## Patentansprüche

1. Verfahren zum kontinuierlichen Beschichten von nichtleitenden Folien mittels einer Hochleistungs-Beschichtungsquelle im Vakuum unter Kondensation des Beschichtungsmaterials auf einem auf einer rotierenden Kühlwalze oberhalb der Hochleistungs-Beschichtungsquelle aufliegenden Abschnitt der Folie und unter Beaufschlagung der Folie vor dem Beschichten mit Ladungsträgern, um den Ladungszustand der Folie zu verändern, **dadurch gekennzeichnet,** daß die Folie während ihrer Auflage auf der Kühlwalze vor dem Beschichten einem Elektronenbeschuß durch einen thermischen Emitter mit einer Spannung zwischen 3 und 10 kV, vorzugsweise zwischen 4 und 8 kV, ausgesetzt wird.

2. Verfahren nach Anspruch 1, **dadurch gekennzeichnet,** daß die Folie aus einer Wickelkammer mit einem Druck zwischen 10⁻² und 10⁻³ mbar abgezogen, durch eine Zwischenkammer mit einem Druck zwischen 10⁻³ und 10⁻⁴ mbar hindurch in eine Beschichtungskammer mit einem Druck zwischen 10⁻⁴ und 10⁻⁵ mbar geführt, beschichtet und mit umgekehrten Druckverhältnissen wieder in die Wickelkammer zurückgeführt wird, wobei der Elektronenbeschuß in der Zwischenkammer durchgeführt wird.

3. Vorrichtung zur Durchführung des Verfahrens nach Anspruch 1, mit einer Hauptvakuumkammer (1), die durch mindestens eine Trennwand (2, 3) in mindestens zwei unabhängig voneinander evakuierbare Teilkammern (4, 6) unterteilt ist, die mindestens eine Wickelkammer und eine Beschichtungskammer bilden, mit einer drehbaren Kühlwalze (14), die in Fenstern (16, 17) der mindestens einen Trennwand (2, 3) angeordnet ist, wobei die Fensterkanten (16a, 16b; 17a, 17b) gegenüber der Kühlwalze (14) und der Folie (12, 12a) Spaltblenden bilden, **dadurch gekennzeichnet,** daß außerhalb der Beschichtungskammer ein thermischer Elektronen-Emitter (23) angeordnet ist, durch den Elektronen in Richtung auf die Kühltrommel (14) beschleunigbar sind.

4. Vorrichtung nach Anspruch 3, **dadurch gekennzeichnet,** daß durch zwei Trennwände (2, 3) drei unabhängig voneinander evakuierbare Teilkammern (4, 5, 6) gebildet sind, die eine Wickelkammer, eine Zwischenkammer und eine Beschichtungskammer bilden, und daß der Elektronen-Emitter (23) in der eine Zwischenkammer bildenden Teilkammer (5) angeordnet ist.

5. Vorrichtung nach Anspruch 3, **dadurch gekennzeichnet,** daß der Elektronen-Emitter (23) ein parallel zur Achse (24) der Kühlwalze (14) verlaufender, auf Emissionstemperatur aufheizbarer Glühdraht ist, der von einer Hohlanode umgeben ist, die in Richtung auf die Kühlwalze (14) einen Schlitz (25a) für den Austritt der Elektronen aufweist, im übrigen aber geschlossen ist.
